# EUROPEAN PATENT APPLICATION

(11) **EP 4 043 844 A1**
(43) Date of publication of application: **17.08.2022**
(21) Application number: 20874519.0
(22) Date of filing: 18.09.2020
(51) Int. Cl.: G01J 1/02, G01J 1/44, H01L 35/00, H01L 35/22, H01L 35/34, H01L 51/42, H01L 27/144, H01L 27/30

(54) **ELECTROMAGNETIC WAVE DETECTION DEVICE, ELECTROMAGNETIC DETECTION SYSTEM, AND ELECTROMAGNETIC DETECTION METHOD**

(30) Priority: 10.10.2019 JP 2019186911
(71) Applicant: Sony Semiconductor Solutions Corporation, Atsugi-shi, Kanagawa 243-0014 (JP)
(72) Inventor: YAMAGUCHI, Tetsuji, Atsugi-shi, Kanagawa 243-0014 (JP)
(74) Representative: Müller Hoffmann & Partner
(86) International application number: PCT/JP2020/035386
(87) International publication number: WO 2021/070594

(57) **Abstract**

An electromagnetic wave detection device including: an electromagnetic wave absorption layer including a low-dimensional electronic material that absorbs an electromagnetic wave; a first electrode provided on a first principal surface of the electromagnetic wave absorption layer; a second electrode provided on a second principal surface of the electromagnetic wave absorption layer, the second principal surface being opposed to the first principal surface; and a read circuit that reads, from the second electrode, a signal generated by thermoelectric conversion of heat generated by the electromagnetic wave absorption layer that has absorbed the electromagnetic wave.

## Description

### Technical Field

The present disclosure relates to an electromagnetic wave detection device, an electromagnetic wave detection system, and an electromagnetic wave detection method.

### Background Art

In recent years, a sensor that acquires information from an object by detecting light or an electromagnetic wave unperceivable by human has been under development.

For example, a sensor that detects a terahertz wave in a frequency band of 0.1 THz to 50 THz by using a carbon nanotube has been developed (e.g., PTL 1). The terahertz wave is an electromagnetic wave that corresponds to an intermediate region between light and a radio wave and is able to construct an optical measurement system. The terahertz wave has therefore been attracting attention in recent years.

### Citation List

### Patent Literature

PTL 1: International Publication No. 2017/188438

### Summary of the Invention

However, it is difficult to say that a sensor structure is studied sufficiently for such a sensor that detects light or an electromagnetic wave unperceivable by human, as compared with a sensor that detects visible light or the like. Hence, further study on the sensor structure is desired for further improvement in performance or reduction in cost of the sensor.

Accordingly, it is desirable to provide an electromagnetic wave detection device and an electromagnetic wave detection system having a structure suitable for further improvement in performance or reduction in cost, and an electromagnetic wave detection method using the electromagnetic wave detection device and the electromagnetic wave detection system.

An electromagnetic wave detection device according to one embodiment of the present disclosure includes: an electromagnetic wave absorption layer including a low-dimensional electronic material that absorbs an electromagnetic wave; a first electrode provided on a first principal surface of the electromagnetic wave absorption layer; a second electrode provided on a second principal surface of the electromagnetic wave absorption layer, the second principal surface being opposed to the first principal surface; and a read circuit that reads, from the second electrode, a signal generated by thermoelectric conversion of heat generated by the electromagnetic wave absorption layer that has absorbed the electromagnetic wave.

In addition, an electromagnetic wave detection system according to one embodiment of the present disclosure includes: an electromagnetic wave detection device; and a shutter that controls incidence of an electromagnetic wave on the electromagnetic wave detection device. The electromagnetic wave detection device includes an electromagnetic wave absorption layer including a low-dimensional electronic material that absorbs the electromagnetic wave, a first electrode provided on a first principal surface of the electromagnetic wave absorption layer, a second electrode provided on a second principal surface of the electromagnetic wave absorption layer, the second principal surface being opposed to the first principal surface, and a read circuit that reads, from the second electrode, a signal generated by thermoelectric conversion of heat generated by the electromagnetic wave absorption layer that has absorbed the electromagnetic wave.

In addition, an electromagnetic wave detection method according to one embodiment of the present disclosure includes: absorbing an electromagnetic wave by a low-dimensional electronic material included in an electromagnetic wave absorption layer whose principal surfaces opposed to each other are sandwiched between a first electrode and a second electrode; performing thermoelectric conversion of heat generated by the electromagnetic wave absorption layer by absorption of the electromagnetic wave; and reading a signal generated by the thermoelectric conversion from the second electrode.

In the electromagnetic wave detection device, the electromagnetic wave detection system, and the electromagnetic wave detection method according to one embodiment of the present disclosure, it is possible to read, from the second electrode, the signal based on the thermoelectric conversion using a temperature difference between the first electrode provided on the first principal surface of the electromagnetic wave absorption layer including the low-dimensional electronic material that absorbs the electromagnetic wave, and the second electrode provided on the second principal surface of the electromagnetic wave absorption layer opposed to the first principal surface. This makes it possible to read, from the second electrode, the signal corresponding to energy of the electromagnetic wave absorbed by the electromagnetic wave absorption layer, for example.

### Brief Description of Drawings

[FIG. 1] FIG. 1 is a schematic diagram illustrating a configuration of a cross section and a top surface of an electromagnetic wave detection device according to a first embodiment of the present disclosure.
[FIG. 2A] FIG. 2A is an explanatory diagram illustrating the Seebeck effect in an n-type semiconductor.
[FIG. 2B] FIG. 2B is an explanatory diagram illustrating the Seebeck effect in a p-type semiconductor.
[FIG. 3] FIG. 3 is a flowchart illustrating a flow of an electromagnetic wave detection method used by the electromagnetic wave detection device according to the embodiment.
[FIG. 4A] FIG. 4A is a perspective view of a configuration of an electromagnetic wave detection device according to a first comparative example.
[FIG. 4B] FIG. 4B is a schematic diagram illustrating an energy diagram of an electromagnetic wave absorption layer in the electromagnetic wave detection device illustrated in FIG. 4A.
[FIG. 5A] FIG. 5A is a perspective view of a configuration of an electromagnetic wave detection device according to a second comparative example.
[FIG. 5B] FIG. 5B is a schematic diagram illustrating an energy diagram of an electromagnetic wave absorption layer in the electromagnetic wave detection device illustrated in FIG. 5A.
[FIG. 6] FIG. 6 is a schematic diagram illustrating a configuration of a cross section of an electromagnetic wave detection device according to a second embodiment of the present disclosure.
[FIG. 7A] FIG. 7A is an energy diagram illustrating a relationship between energy levels of a buffer layer and an electromagnetic wave absorption layer in a case where the electromagnetic wave absorption layer is an n-type semiconductor layer.
[FIG. 7B] FIG. 7B is an energy diagram illustrating a relationship between energy levels of the buffer layer and the electromagnetic wave absorption layer in a case where the electromagnetic wave absorption layer is a p-type semiconductor layer.
[FIG. 8] FIG. 8 is a schematic diagram illustrating a configuration of a cross section and a top surface of an electromagnetic wave detection device according to a third embodiment of the present disclosure.
[FIG. 9] FIG. 9 is a schematic diagram illustrating a configuration of a cross section of an electromagnetic wave detection device according to a fourth embodiment of the present disclosure.
[FIG. 10A] FIG. 10A is a vertical cross-sectional view of a step of a method of forming a heat insulating part in the electromagnetic wave detection device according to the embodiment.
[FIG. 10B] FIG. 10B is a vertical cross-sectional view of a step of the method of forming the heat insulating part in the electromagnetic wave detection device according to the embodiment.
[FIG. 10C] FIG. 10C is a vertical cross-sectional view of a step of the method of forming the heat insulating part in the electromagnetic wave detection device according to the embodiment.
[FIG. 10D] FIG. 10D is a vertical cross-sectional view of a step of the method of forming the heat insulating part in the electromagnetic wave detection device according to the embodiment.
[FIG. 10E] FIG. 10E is a vertical cross-sectional view of a step of the method of forming the heat insulating part in the electromagnetic wave detection device according to the embodiment.
[FIG. 11] FIG. 11 is a schematic diagram illustrating a configuration of a cross section of an electromagnetic wave detection device according to a fifth embodiment of the present disclosure.
[FIG. 12A] FIG. 12A is a vertical cross-sectional view of a step of a method of manufacturing the electromagnetic wave detection device according to the embodiment.
[FIG. 12B] FIG. 12B is a vertical cross-sectional view of a step of the method of manufacturing the electromagnetic wave detection device according to the embodiment.
[FIG. 12C] FIG. 12C is a vertical cross-sectional view of a step of the method of manufacturing the electromagnetic wave detection device according to the embodiment.
[FIG. 12D] FIG. 12D is a vertical cross-sectional view of a step of the method of manufacturing the electromagnetic wave detection device according to the embodiment.
[FIG. 12E] FIG. 12E is a vertical cross-sectional view of a step of the method of manufacturing the electromagnetic wave detection device according to the embodiment.
[FIG. 12F] FIG. 12F is a vertical cross-sectional view of a step of the method of manufacturing the electromagnetic wave detection device according to the embodiment.
[FIG. 13] FIG. 13 is a block diagram illustrating an example of an outline configuration of an electromagnetic wave detection system.
[FIG. 14] FIG. 14 illustrates an example of a flowchart of imaging operation in the electromagnetic wave detection system.
[FIG. 15] FIG. 15 is a block diagram depicting an example of schematic configuration of a vehicle control system.
[FIG. 16] FIG. 16 is a diagram of assistance in explaining an example of installation positions of an outside-vehicle information detecting section and an imaging section.

### Modes for Carrying Out the Invention

In the following, description is given of embodiments of the present disclosure in detail with reference to the drawings. The embodiments described below are specific examples of the present disclosure, and the technology according to the present disclosure should not be limited to the following embodiments. Further, arrangements, dimensions, dimensional ratios, and the like of each component of the present disclosure are not limited to those illustrated in the drawings.

It is to be noted that the description is given in the following order.
1. First Embodiment
   1.1. Configuration of Electromagnetic Wave Detection Device
   1.2. Electromagnetic Wave Detection Method
   1.3. Description of Effects
2. Second Embodiment
3. Third Embodiment
4. Fourth Embodiment
   4.1. Configuration of Electromagnetic Wave Detection Device
   4.2. Method of Forming Heat Insulating Part
5. Fifth Embodiment
   5.1. Configuration of Electromagnetic Wave Detection Device
   5.2. Method of Manufacturing Electromagnetic Wave Detection Device
6. Application Examples

### <1. First Embodiment

### (1.1. Configuration of Electromagnetic Wave Detection Device)

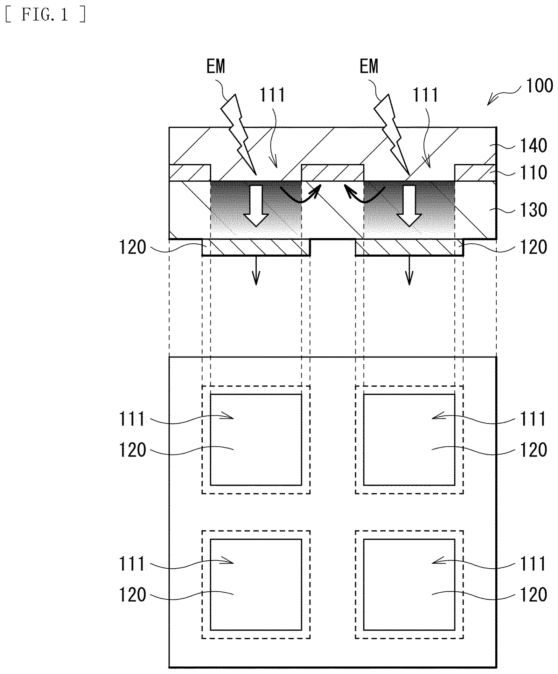

First, a configuration of an electromagnetic wave detection device according to a first embodiment of the present disclosure is described with reference to FIG. 1. FIG. 1 is a schematic diagram illustrating a configuration of a cross section and a top surface of an electromagnetic wave detection device 100 according to the present embodiment.

As illustrated in FIG. 1, the electromagnetic wave detection device 100 includes, for example, an electromagnetic wave absorption layer 130, a first electrode 110, a second electrode 120, and an insulating layer 140.

The electromagnetic wave detection device 100 is, for example, a two-dimensional array type detection device in which a plurality of sensor pixels that detect an electromagnetic wave EM are two-dimensionally arranged. In the following description, a region in which the sensor pixels that detect the electromagnetic wave EM are two-dimensionally arranged is also referred to as a pixel region.

The electromagnetic wave absorption layer 130 is a semiconductor layer including a low-dimensional electronic material. The electromagnetic wave absorption layer 130 absorbs the electromagnetic wave EM incident on the electromagnetic wave detection device 100, and converts the absorbed electromagnetic wave into heat. By converting the incident electromagnetic wave EM into heat, the electromagnetic wave absorption layer 130 is able to generate electromotive force corresponding to the electromagnetic wave EM by thermoelectric conversion.

Specifically, the electromagnetic wave absorption layer 130 is able to form a temperature gradient in a thickness direction, by absorbing and converting the incident electromagnetic wave EM into heat. This enables the electromagnetic wave detection device 100 to extract, from the second electrode 120, a signal corresponding to the electromagnetic wave EM incident on each pixel, by converting a temperature difference caused in the thickness direction of the electromagnetic wave absorption layer 130 into the electromotive force by the Seebeck effect.

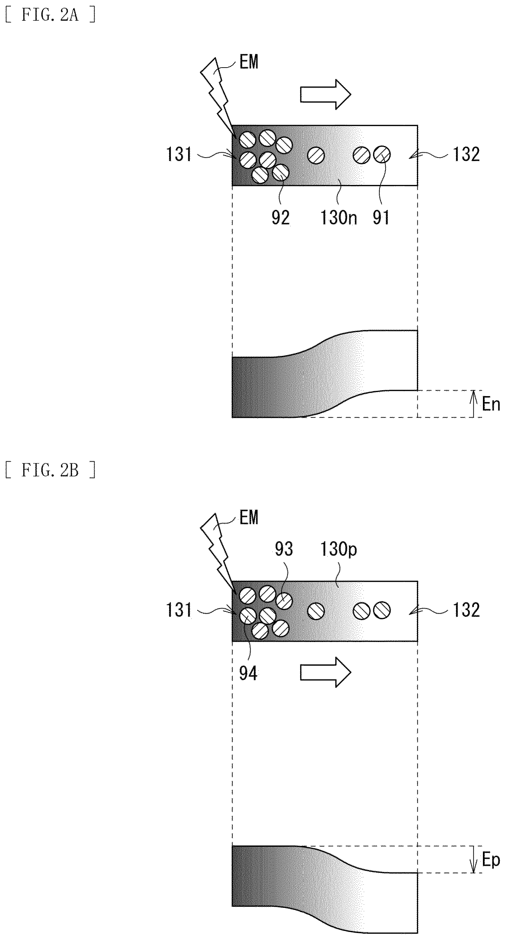

Here, the Seebeck effect is described with reference to FIG. 2A and FIG. 2B. FIG. 2A is an explanatory diagram illustrating the Seebeck effect in an n-type semiconductor. FIG. 2B is an explanatory diagram illustrating the Seebeck effect in a p-type semiconductor.

The Seebeck effect, which is one kind of thermoelectric effect, is a phenomenon in which a temperature difference in an object is directly converted into voltage.

For example, as illustrated in FIG. 2A, in the electromagnetic wave absorption layer 130n that is an n-type semiconductor, carriers (i.e., electrons) 91 are supplied by donors 92 being ionized by thermal excitation. Therefore, in a case where a high-temperature part 131 and a low-temperature part 132 are generated in the electromagnetic wave absorption layer 130n by absorption of the electromagnetic wave EM or the like, concentration of the carriers 91 in the high-temperature part 131 increases exponentially with respect to temperature. In such a case, a concentration gradient of the carriers 91 is formed between the high-temperature part 131 and the low-temperature part 132. Thus, the carriers 91 of the high-temperature part 131 are diffused toward the low-temperature part 132 by diffusing power resulting from a concentration difference.

At this time, the ionized donors 92 are fixed as ions in a crystal, and therefore are not diffused. Thus, the high-temperature part 131 assumes positive electric charge opposite to electric charge of the carriers 91. Thus, force that pushes the carriers 91 back to the high-temperature part 131 is generated between the high-temperature part 131 and the low-temperature part 132 by Coulomb force resulting from electric charge imbalance. Consequently, electromotive force En matching the diffusing power resulting from the concentration difference of the carriers 91 is generated between the high-temperature part 131 and the low-temperature part 132 of the electromagnetic wave absorption layer 130n.

On the other hand, as illustrated in FIG. 2B, in the electromagnetic wave absorption layer 130p that is a p-type semiconductor, carriers 94 (i.e., holes) are supplied by acceptors 93 being ionized by thermal excitation. Therefore, in a case where a high-temperature part 131 and a low-temperature part 132 are generated in the electromagnetic wave absorption layer 130p by absorption of the electromagnetic wave EM or the like, concentration of the carriers 94 in the high-temperature part 131 increases exponentially with respect to temperature. In such a case, a concentration gradient of the carriers 94 is formed between the high-temperature part 131 and the low-temperature part 132. Thus, the carriers 94 of the high-temperature part 131 are diffused toward the low-temperature part 132 by diffusing power resulting from a concentration difference.

At this time, the ionized acceptors 93 are fixed as ions in a crystal, and therefore are not diffused. Thus, the high-temperature part 131 assumes negative electric charge opposite to electric charge of the carriers 94. Thus, force that pushes the carriers 94 back to the high-temperature part 131 is generated between the high-temperature part 131 and the low-temperature part 132 by Coulomb force resulting from electric charge imbalance. Consequently, electromotive force Ep matching the diffusing power resulting from the concentration difference of the carriers 91 is generated between the high-temperature part 131 and the low-temperature part 132 of the electromagnetic wave absorption layer 130n.

In the electromagnetic wave detection device 100 according to the present embodiment, by the electromagnetic wave EM being absorbed by the electromagnetic wave absorption layer 130 and converted into heat, a first principal surface side of the electromagnetic wave absorption layer 130 becomes a high-temperature part, and a second principal surface side of the electromagnetic wave absorption layer 130 becomes a low-temperature part. Thus, in the electromagnetic wave absorption layer 130 that is a semiconductor layer, electromotive force resulting from the Seebeck effect is generated between the first principal surface side and the second principal surface side. Consequently, the electromagnetic wave detection device 100 is able to detect an amount of the incident electromagnetic wave EM, by detecting a potential difference between the first electrode 110 and the second electrode 120 or an amount of current that flows between the first electrode 110 and the second electrode 120.

The electromagnetic wave absorption layer 130 may be provided as a common layer spreading over the entire pixel region. In the electromagnetic wave detection device 100 according to the present embodiment, a thickness of the electromagnetic wave absorption layer 130 is preferably several hundreds of nm or more, to obtain sufficient absorption of the electromagnetic wave. In addition, the thickness of the electromagnetic wave absorption layer 130 is further preferably 1 µm or more, to form a temperature gradient in the thickness direction of the electromagnetic wave absorption layer 130. It is to be noted that, in consideration of a resolution limit based on a wavelength of the electromagnetic wave EM to be detected, a size of one pixel in the electromagnetic wave absorption layer 130 is several µm to several hundreds of µm. In the electromagnetic wave detection device 100 according to the present embodiment, providing the electromagnetic wave absorption layer 130 as a common layer spreading over the entire pixel region makes it possible to further simplify a manufacturing process of the electromagnetic wave detection device 100.

The low-dimensional electronic material included in the electromagnetic wave absorption layer 130 is a semiconductor material in which internal electron transfer is restricted within a region of two or less dimensions. Specifically, the low-dimensional electronic material is a two-dimensional electronic material such as graphene, a one-dimensional electronic material such as a carbon nanotube, or a zero-dimensional electronic material such as fullerene. For example, the electromagnetic wave absorption layer 130 may include a carbon nanotube or graphene as the low-dimensional electromagnetic material.

In a case where the electromagnetic wave absorption layer 130 includes a carbon nanotube, the electromagnetic wave absorption layer 130 is able to absorb the electromagnetic wave EM in a very wide frequency band from an ultraviolet region to a terahertz wave region, and convert the absorbed electromagnetic wave EM into heat. For example, the electromagnetic wave absorption layer 130 may cause the electromagnetic wave detection device 100 to function as a terahertz wave detection device, by absorbing the electromagnetic wave EM in a frequency band of 100 GHz or more and 75 THz or less.

The first electrode 110 is provided on a first principal surface of the electromagnetic wave absorption layer 130. Specifically, the first electrode 110 is provided as a common electrode to spread over the entire first principal surface of the electromagnetic wave absorption layer 130, and is provided to have a plurality of apertures 111 two-dimensionally arranged. That is, the first electrode 110 may be provided to spread over the entire first principal surface of the electromagnetic wave absorption layer 130, as a grid-shaped common electrode that defines each of the pixels. The plurality of apertures 111 provided for the first electrode 110 function as quadrangular pixels.

The first electrode 110 may include an electrically conductive material that does not absorb the electromagnetic wave EM in a frequency band that is a detection target of the electromagnetic wave detection device 100. Specifically, the first electrode 110 may include an electrically conductive material including aluminum (Al), titanium (Ti), titanium nitride (TiN), tungsten (W), Ni (nickel), copper (Cu), bismuth (Bi), or indium (In). For example, the first electrode 110 may include an electrically conductive material including Ti, Bi, or Ni.

The second electrode 120 is provided on a second principal surface of the electromagnetic wave absorption layer 130 opposed to the first principal surface. Specifically, the second electrodes 120 are provided in regions corresponding to the plurality of apertures 111 provided for the first electrode 110, to be separated from each other for each pixel. For example, the second electrode 120 may be provided in a quadrangular shape to correspond to each of the apertures 111 of the first electrode 110. In addition, an unillustrated read circuit is electrically coupled to the second electrode 120, and voltage or current corresponding to the incident electromagnetic wave EM is read, for each pixel, from the second electrode 120.

The second electrode 120 may include an electrically conductive material. Specifically, the second electrode 120 may include an electrically conductive material including aluminum (Al), titanium (Ti), titanium nitride (TiN), tungsten (W), copper (Cu), or indium (In). For example, the second electrode 120 may include an electrically conductive material including Ti.

The first electrode 110 and the second electrode 120 may include electrically conductive materials having different heat conductivities from each other. In such a case, the first electrode 110 and the second electrode 120 are able to make the temperature gradient in the thickness direction of the electromagnetic wave absorption layer 130 larger by heat transfer from the electromagnetic wave absorption layer 130.

In addition, the first electrode 110 is able to suppress thermal crosstalk between adjacent pixels, and separate temperatures of the adjacent pixels more clearly, by including an electrically conductive material with high heat conductivity. However, in such a case, an electromotive force between the first electrode 110 and the electromagnetic wave absorption layer 130 and an electromotive force between the second electrode 120 and the electromagnetic wave absorption layer 130 have opposite directions. Thus, components that cancel each other may be generated in the electromotive forces between the first electrode 110 and the second electrode 120. Therefore, it is important to appropriately select the electrically conductive materials included in the first electrode 110 and the second electrode 120, in consideration of sensitivity to the electromagnetic wave EM to be detected and a magnitude of crosstalk between the pixels.

The insulating layer 140 protects the electromagnetic wave absorption layer 130 by being provided on the electromagnetic wave absorption layer 130 and the first electrode 110 by using an insulating material. Because the insulating layer 140 is provided on the electromagnetic wave EM incidence side with respect to the electromagnetic wave absorption layer 130, the insulating layer 140 desirably includes an insulating material whose absorptance for the electromagnetic wave EM in the detection target frequency band is lower than that of the electromagnetic wave absorption layer 130. In addition, to suppress diffusion of heat generated by absorbing the electromagnetic wave EM to the outside of the electromagnetic wave absorption layer 130, the insulating layer 140 desirably includes an insulating material with heat conductivity lower than that of the electromagnetic wave absorption layer 130. For example, in a case where the electromagnetic wave absorption layer 130 includes a carbon nanotube, the insulating layer 140 may include an insulating material including silicon oxide (SiOₓ), silicon nitride (SiNₓ), or aluminum oxide (Al₂O₃).

With the above configuration, the electromagnetic wave detection device 100 according to the present embodiment is able to generate a temperature gradient in the thickness direction of the electromagnetic wave absorption layer 130 by absorbing the electromagnetic wave EM by the electromagnetic wave absorption layer 130, and generate electromotive force based on the temperature gradient. Consequently, the electromagnetic wave detection device 100 according to the present embodiment is able to read, for each pixel provided in an in-plane direction of the electromagnetic wave absorption layer 130, a signal corresponding to the electromagnetic wave EM incident on the pixel.

Such an electromagnetic wave detection device 100 according to the present embodiment may be manufactured by using a known semiconductor manufacturing method. For example, the electromagnetic wave absorption layer 130 may be formed by using a spin coating method. The first electrode 110 and the second electrode 120 may be formed by using a sputtering method. The insulating layer 140 may be formed by using a CVD (Chemical Vapor Deposition) method.

### (1.2. Electromagnetic Wave Detection Method)

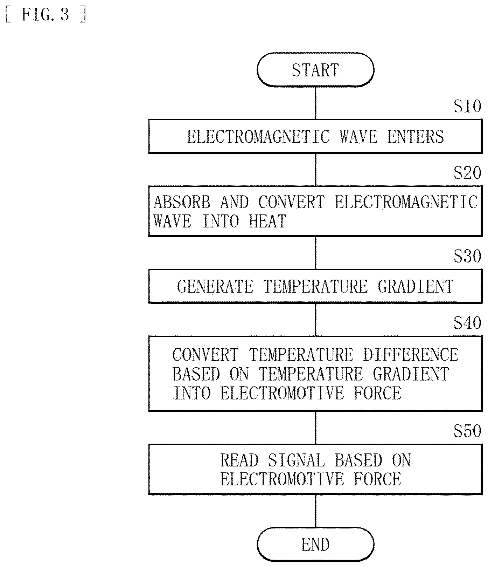

Next, an electromagnetic wave detection method used by the electromagnetic wave detection device according to the present embodiment is described with reference to FIG. 3. FIG. 3 is a flowchart illustrating a flow of the electromagnetic wave detection method used by the electromagnetic wave detection device according to the present embodiment.

As illustrated in FIG. 3, first, the electromagnetic wave EM enters the electromagnetic wave absorption layer 130 of the electromagnetic wave detection device 100 (S10).

In the electromagnetic wave absorption layer 130 on which the electromagnetic wave EM is incident, the incident electromagnetic wave EM is absorbed by the low-dimensional electronic material, and energy of the absorbed electromagnetic wave EM is converted into heat (S20).

Thus, in the electromagnetic wave absorption layer 130, a temperature gradient is generated in which the first electrode 110 on side of the electromagnetic wave EM incidence surface has high temperature and the second electrode 120 opposed to the first electrode 110 has low temperature (S30).

The temperature gradient generated in the electromagnetic wave absorption layer 130 causes a temperature difference between the first electrode 110 and the second electrode 120. The temperature difference between the first electrode 110 and the second electrode 120 is converted into electromotive force by the Seebeck effect (S40).

Thereafter, a signal based on the electromotive force resulting from the Seebeck effect is read from the second electrode 120 (S50).

By operating in accordance with the above-described flow, the electromagnetic wave detection device 100 according to the present embodiment is able to detect the electromagnetic wave EM incident on the electromagnetic wave absorption layer 130.

### (1.3. Description of Effects)

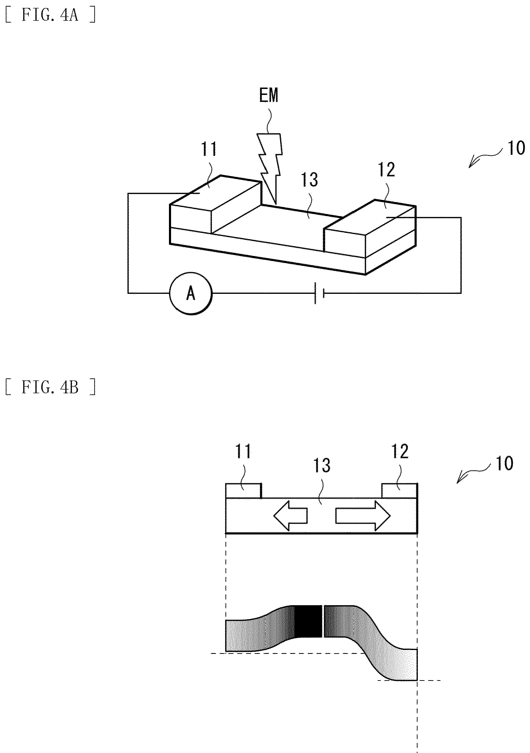

Next, effects of the electromagnetic wave detection device 100 according to the present embodiment are specifically described with reference to FIG. 4A to FIG. 5B, by exemplifying an electromagnetic wave detection device according to a first comparative example and an electromagnetic wave detection device according to a second comparative example for comparison.

FIG. 4A is a perspective view of a configuration of an electromagnetic wave detection device 10 according to a first comparative example. FIG. 4B is a schematic diagram illustrating an energy diagram of an electromagnetic wave absorption layer 13 in the electromagnetic wave detection device 10 illustrated in FIG. 4A.

As illustrated in FIG. 4A, the electromagnetic wave detection device 10 according to the first comparative example is configured by disposing a first electrode 11 and a second electrode 12 separated from each other on one principal surface of the electromagnetic wave absorption layer 13. In the first comparative example, the electromagnetic wave absorption layer 13 is provided as a p-type semiconductor layer, and the first electrode 11 and the second electrode 12 include materials having different heat conductivities from each other.

Here, as illustrated in FIG. 4B, heat generated by the electromagnetic wave absorption layer 13 absorbing the electromagnetic wave EM is diffused toward respective ones of the first electrode 11 and the second electrode 12. Therefore, in the electromagnetic wave absorption layer 13, a middle part becomes a high-temperature part, and end parts provided with respective ones of the first electrode 11 and the second electrode 12 become low-temperature parts. Consequently, electromotive forces resulting from the Seebeck effect are generated between the middle part and the end parts, provided with respective ones of the first electrode 11 and the second electrode 12, of the electromagnetic wave absorption layer 13.

For example, in a case where the second electrode 12 includes a material having higher heat conductivity than that of the first electrode 11, in the electromagnetic wave absorption layer 13, the end part provided with the second electrode 12 has lower temperature than the end part provided with the first electrode 11. In such a case, the electromotive force generated between the middle part and the end part provided with the second electrode 12 of the electromagnetic wave absorption layer 13 is larger than the electromotive force generated between the middle part and the end part provided with the first electrode 11 of the electromagnetic wave absorption layer 13. Consequently, the electromagnetic wave detection device 10 according to the first comparative example is able to detect incidence of the electromagnetic wave EM on the electromagnetic wave absorption layer 13, on the basis of a difference between the electromotive forces generated between the middle part and the end parts, provided with respective ones of the first electrode 11 and the second electrode 12, of the electromagnetic wave absorption layer 13.

However, in the electromagnetic wave detection device 10, the electromotive forces between the middle part and the end parts, provided with respective ones of the first electrode 11 and the second electrode 12, of the electromagnetic wave absorption layer 13 cancel a portion of each other, which results in a decrease in detection sensitivity. In addition, in the electromagnetic wave detection device 10, the first electrode 11 and the second electrode 12 are provided on the first principal surface of the electromagnetic wave absorption layer 13 configuring a pixel. Thus, an aperture ratio of the electromagnetic wave absorption layer 13 in each pixel decreases by an amount corresponding to the first electrode 11 and the second electrode 12.

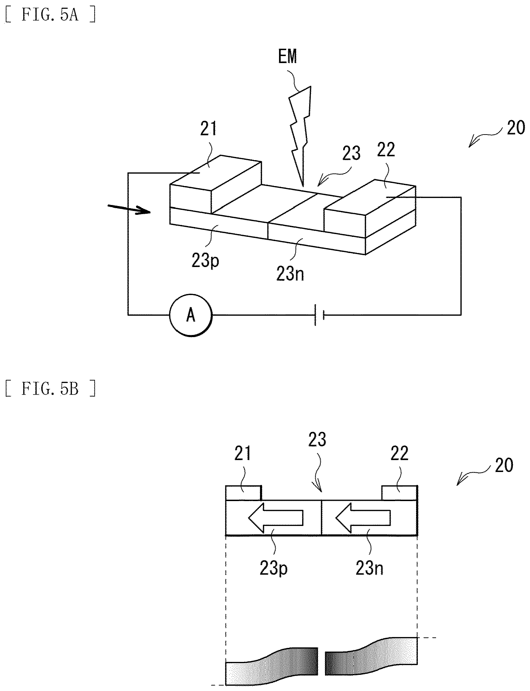

In addition, FIG. 5A is a perspective view of a configuration of an electromagnetic wave detection device 20 according to a second comparative example. FIG. 5B is a schematic diagram illustrating an energy diagram of an electromagnetic wave absorption layer 23 in the electromagnetic wave detection device 20 illustrated in FIG. 5A.

As illustrated in FIG. 5A, the electromagnetic wave detection device 20 according to the second comparative example is configured by disposing a first electrode 21 and a second electrode 22 separated from each other on one principal surface of the electromagnetic wave absorption layer 23. In the second comparative example, the first electrode 11 and the second electrode 12 include the same electrically conductive material, and the electromagnetic wave absorption layer 23 is provided as a hetero junction layer including a p-type semiconductor layer 23p and an n-type semiconductor layer 23n joined together.

Here, as illustrated in FIG. 5B, heat generated by the electromagnetic wave absorption layer 23 absorbing the electromagnetic wave EM is diffused toward respective ones of the first electrode 21 and the second electrode 22. Therefore, in the electromagnetic wave absorption layer 23, a middle part near a junction surface of the p-type semiconductor layer 23p and the n-type semiconductor layer 23n becomes a high-temperature part, and end parts provided with respective ones of the first electrode 21 and the second electrode 22 become low-temperature parts. Consequently, electromotive forces resulting from the Seebeck effect are generated between the middle part and the end parts, provided with respective ones of the first electrode 21 and the second electrode 22, of the electromagnetic wave absorption layer 23.

At this time, in the p-type semiconductor layer 23p, electromotive force causing the end part provided with the first electrode 21 to have a higher potential than the middle part near the junction surface is generated. In addition, in the n-type semiconductor layer 23n, electromotive force causing the end part provided with the second electrode 22 to have a lower potential than the middle part near the junction surface is generated. Consequently, the electromagnetic wave detection device 20 according to the second comparative example is able to align a direction of the electromotive force throughout the entire electromagnetic wave absorption layer 23. This makes it possible to detect incidence of the electromagnetic wave EM on the electromagnetic wave absorption layer 23, on the basis of the sum of the electromotive forces generated between the end parts provided with respective ones of the first electrode 21 and the second electrode 22.

In the electromagnetic wave detection device 20 according to the second comparative example, mutual cancellation of electromotive force does not occur between the electromagnetic wave absorption layer 23 and respective ones of the first electrode 11 and the second electrode 12. This makes it possible to improve detection sensitivity as compared with the electromagnetic wave detection device 10 according to the first comparative example. However, it is difficult to provide, in the electromagnetic wave absorption layer 23 including the low-dimensional electronic material, the electromagnetic wave absorption layer 23 including the p-type semiconductor layer 23p and the n-type semiconductor layer 23n joined together in the in-plane direction.

For example, in a case where the electromagnetic wave absorption layer 23 includes a carbon nanotube as the low-dimensional electronic material, to change the carbon nanotube that is a p-type semiconductor into an n-type semiconductor, the carbon nanotube is to be modified by a wet process using crown ether or the like. However, it is very difficult to change, by using a wet process, a portion of the electromagnetic wave absorption layer 23 provided for each of pixels into the n-type semiconductor layer 23n so as to prevent variation between the pixels.

In contrast, in the electromagnetic wave detection device 100 according to the present embodiment, it is possible to form a temperature gradient in the thickness direction of the electromagnetic wave absorption layer 130, and to extract electromotive force generated by the temperature gradient, by the first electrode 110 provided on the first principal surface of the electromagnetic wave absorption layer 130, and the second electrode 120 provided on the second principal surface of the electromagnetic wave absorption layer 130 opposed to the first principal surface.

With this configuration, in the electromagnetic wave detection device 100 according to the present embodiment, mutual cancellation of the electromotive force generated by the temperature gradient does not occur as in the electromagnetic wave detection device 10 according to the first comparative example. This makes it possible to improve the detection sensitivity for the electromagnetic wave EM. In addition, in the electromagnetic wave detection device 100 according to the present embodiment, each of the apertures 111 provided for the first electrode 110 serves as a pixel. This makes it possible to achieve a very high aperture ratio in each pixel. Furthermore, in the electromagnetic wave detection device 100 according to the present embodiment, a hetero junction is not formed in the electromagnetic wave absorption layer 23 as in the electromagnetic wave detection device 20 according to the second comparative example. This makes it possible to suppress an increase in difficulty of the manufacturing process.

As described above, in the electromagnetic wave detection device 100 according to the present embodiment, it is possible to suppress a decrease in the aperture ratio in each pixel, and to suppress an increase in the difficulty of the manufacturing process. Consequently, the present embodiment makes it possible to provide the electromagnetic wave detection device 100 having a structure suitable for further improvement in performance or reduction in cost.

### <2. Second Embodiment

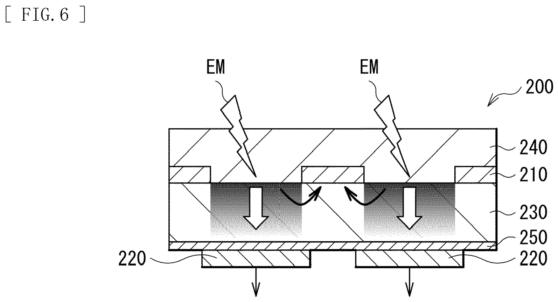

Next, a configuration of an electromagnetic wave detection device according to a second embodiment of the present disclosure is described with reference to FIG. 6 to FIG. 7B. FIG. 6 is a schematic diagram illustrating a configuration of a cross section of an electromagnetic wave detection device 200 according to the present embodiment.

As illustrated in FIG. 6, the electromagnetic wave detection device 200 includes, for example, an electromagnetic wave absorption layer 230, a first electrode 210, a second electrode 220, an insulating layer 240, and a buffer layer 250. It is to be noted that the electromagnetic wave absorption layer 230, the first electrode 210, the second electrode 220, and the insulating layer 240 are substantially similar to the electromagnetic wave absorption layer 130, the first electrode 110, the second electrode 120, and the insulating layer 140 described with reference to FIG. 1, and description thereof is therefore omitted here.

The buffer layer 250 is provided between the electromagnetic wave absorption layer 230 and the second electrode 220. Specifically, the buffer layer 250 is provided to be sandwiched in a stacking direction between the electromagnetic wave absorption layer 230 and the second electrode 220. The buffer layer 250 is provided to suppress occurrence of noise due to flow of carriers from the second electrode 220 into the electromagnetic wave absorption layer 230.

For example, the electromagnetic wave detection device 200 has, as an operation mode, a mode of applying voltage to the first electrode 210, and sequentially extracting carriers from the second electrode 220 without saturating electromotive force based on heat. With this configuration, the electromagnetic wave detection device 200 is able to perform signal processing, such as amplification, on the extracted carriers, by accumulating the extracted carriers in a floating diffusion or the like.

However, the extracted carriers can flow into the electromagnetic wave absorption layer 230 again via the second electrode 220 to cause noise. In the electromagnetic wave detection device 200 according to the present embodiment, it is possible to suppress occurrence of noise by providing the buffer layer 250 that suppresses inflow of carriers between the electromagnetic wave absorption layer 230 and the second electrode 220.

The buffer layer 250 is enabled to achieve the above-described function by appropriately setting its energy level with respect to the electromagnetic wave absorption layer 230.

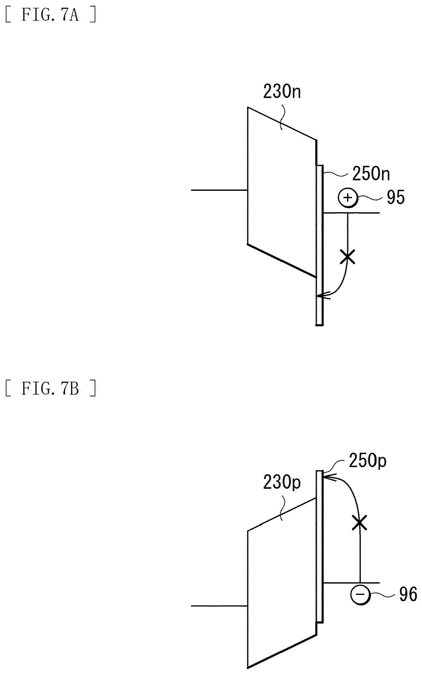

Here, FIG. 7A and FIG. 7B illustrate relationships between energy levels of the buffer layer 250 and the electromagnetic wave absorption layer 230 for achievement of the above-described function. FIG. 7A is an energy diagram illustrating the relationship between the energy levels of the buffer layer 250 and the electromagnetic wave absorption layer 230 in a case where the electromagnetic wave absorption layer 230 is an n-type semiconductor layer. FIG. 7B is an energy diagram illustrating the relationship between the energy levels of the buffer layer 250 and the electromagnetic wave absorption layer 230 in a case where the electromagnetic wave absorption layer 230 is a p-type semiconductor layer.

As illustrated in FIG. 7A, in a case where the electromagnetic wave absorption layer 230 is an n-type semiconductor layer, an energy level 250n of the buffer layer 250 may be provided to be deeper (i.e., to have a larger absolute value) than an energy level 230n of the electromagnetic wave absorption layer 230. Specifically, the buffer layer 250 may be provided to have a larger ionization potential than the electromagnetic wave absorption layer 230. For example, the ionization potential of the buffer layer 250 corresponds to a lower end of the energy level 250n of the buffer layer 250. With this configuration, the buffer layer 250 is able to function as a barrier against flow of a hole 95 from the second electrode 220 into the electromagnetic wave absorption layer 230.

In a case where the electromagnetic wave absorption layer 230 includes an n-type semiconductor carbon nanotube, such a buffer layer 250 may be formed by including, for example, ZnO, PEDOT-PSS, TPBi, α-TPD, α-NPD, β-NPD, CBP, Spiro-OMETAD, or the like as a buffer material.

In addition, as illustrated in FIG. 7B, in a case where the electromagnetic wave absorption layer 230 is a p-type semiconductor layer, an energy level 250p of the buffer layer 250 may be provided to be shallower (i.e., to have a smaller absolute value) than an energy level 230p of the electromagnetic wave absorption layer 230. Specifically, the buffer layer 250 may be provided to have a smaller electron affinity than the electromagnetic wave absorption layer 230. For example, the electron affinity of the buffer layer 250 corresponds to an upper end of the energy level 250n of the buffer layer 250. With this configuration, the buffer layer 250 is able to function as a barrier against flow of an electron 96 from the second electrode 220 into the electromagnetic wave absorption layer 230.

In a case where the electromagnetic wave absorption layer 230 includes a p-type semiconductor carbon nanotube, such a buffer layer 250 may be formed by including, for example, BPhen, NBPhen, B3PyMPM, DCB3T, Bpy-OXD, Bpy-FOXD, 3TPYMB, BP4MPY, BmPyPB, (Alq)₃, TAZ, Spiro-OXDAZ, DBimiBPhen, HNBPhen, Spiro-2NPB, or the like as the buffer material.

In the electromagnetic wave detection device 200 according to the present embodiment having the above configuration, in the operation mode of applying voltage to the first electrode 210, it is possible to suppress occurrence of noise due to flow of carriers from the second electrode 220 into the electromagnetic wave absorption layer 230.

### <3. Third Embodiment

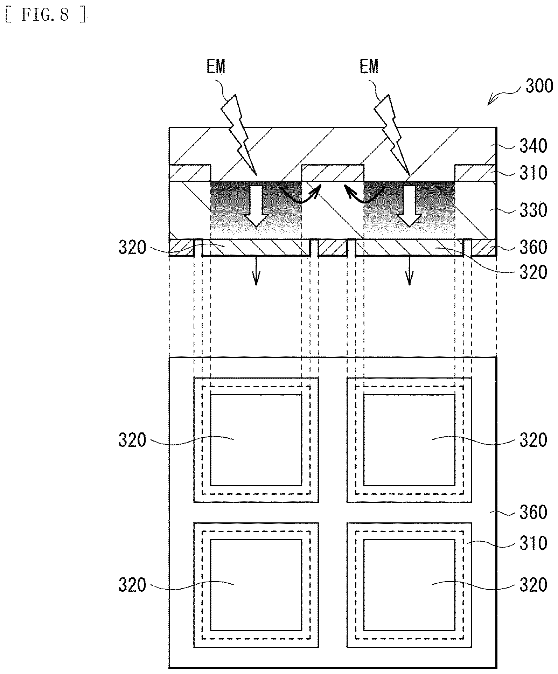

Next, a configuration of an electromagnetic wave detection device according to a third embodiment of the present disclosure is described with reference to FIG. 8. FIG. 8 is a schematic diagram illustrating a configuration of a cross section and a top surface of an electromagnetic wave detection device 300 according to the present embodiment.

As illustrated in FIG. 8, the electromagnetic wave detection device 300 includes, for example, an electromagnetic wave absorption layer 330, a first electrode 310, a second electrode 320, an insulating layer 340, and a shield electrode 360. It is to be noted that the electromagnetic wave absorption layer 330, the first electrode 310, the second electrode 320, and the insulating layer 340 are substantially similar to the electromagnetic wave absorption layer 130, the first electrode 110, the second electrode 120, and the insulating layer 140 described with reference to FIG. 1, and description thereof is therefore omitted here.

The shield electrode 360 may be provided on the second principal surface of the electromagnetic wave absorption layer 330 between the second electrodes 320 by using an electrically conductive material. Specifically, the shield electrode 360 may be provided in a grid shape that surrounds the periphery of each of the second electrodes 320, by using the electrically conductive material. With this configuration, the shield electrode 360 is able to suppress occurrence of capacity coupling between the adjacent second electrodes 320, which makes it possible to suppress electrical crosstalk between the adjacent second electrodes 320.

In addition, the shield electrode 360 is able to suppress exertion of influence, across pixels, of heat generated by the electromagnetic wave absorption layer 330 by absorbing the electromagnetic wave EM (i.e., thermal crosstalk). Specifically, the shield electrode 360 is able to suppress diffused heat from reaching an adjacent pixel, by releasing heat diffused from a pixel that has absorbed the electromagnetic wave EM between the pixels.

The shield electrode 360 may include, for example, the same electrically conductive material as the second electrode 320. In such a case, the shield electrode 360 may be formed on the second principal surface of the electromagnetic wave absorption layer 330 by the same process as the second electrode 320. For example, the shield electrode 360 may include an electrically conductive material including Ti. Alternatively, the shield electrode 360 may include the same electrically conductive material as another wiring line or electrode. For example, the shield electrode 360 may include an electrically conductive material including aluminum (Al), tungsten (W), gold (Au), or copper (Cu).

In the electromagnetic wave detection device 300 according to the present embodiment having the above configuration, it is possible to suppress electrical or thermal crosstalk between the pixels, by providing the shield electrode 360 between the second electrodes 320.

### <4. Fourth Embodiment

### (4.1. Configuration of Electromagnetic Wave Detection Device)

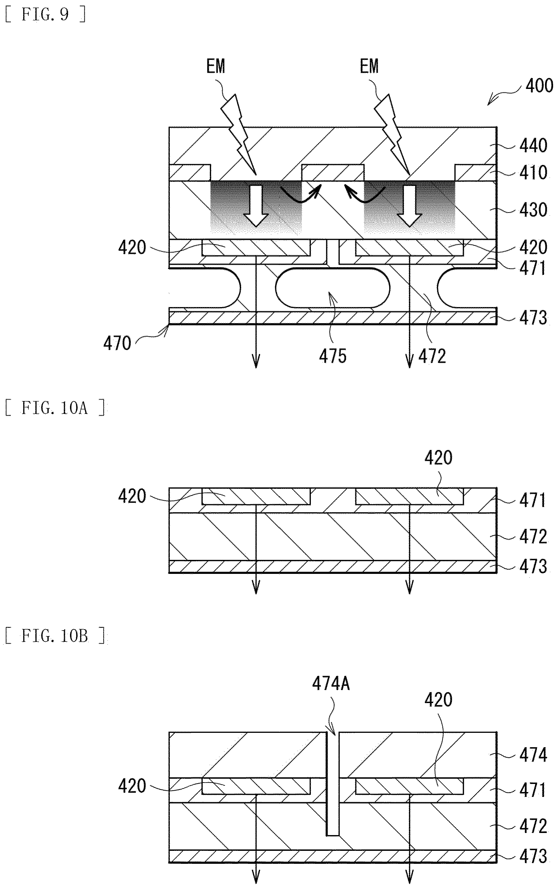

Next, a configuration of an electromagnetic wave detection device according to a fourth embodiment of the present disclosure is described with reference to FIG. 9. FIG. 9 is a schematic diagram illustrating a configuration of a cross section of an electromagnetic wave detection device 400 according to the present embodiment.

As illustrated in FIG. 9, the electromagnetic wave detection device 400 includes, for example, an electromagnetic wave absorption layer 430, a first electrode 410, a second electrode 420, an insulating layer 440, and a heat insulating part 470. In addition, an unillustrated read circuit is provided further below the heat insulating part 470 (i.e., on an opposite side to the side provided with the second electrode 420 with respect to the heat insulating part 470). It is to be noted that the electromagnetic wave absorption layer 430, the first electrode 410, the second electrode 420, and the insulating layer 440 are substantially similar to the electromagnetic wave absorption layer 130, the first electrode 110, the second electrode 120, and the insulating layer 140 described with reference to FIG. 1, and description thereof is therefore omitted here.

The heat insulating part 470 is provided under the electromagnetic wave absorption layer 430 and the second electrode 420. The heat insulating part 470 thermally separates the electromagnetic wave absorption layer 430, and the unillustrated read circuit provided below the heat insulating part 470. Specifically, the heat insulating part 470 includes a first layer 471 provided on the second principal surface of the electromagnetic wave absorption layer 430, a second layer 472 provided under the first layer 471 to include a gap 475, and a third layer 473 provided under the second layer. Because the inside of the gap 475 is vacuum or air with low heat conductivity, the heat insulating part 470 is able to thermally separate the electromagnetic wave absorption layer 430 and the unillustrated read circuit provided on upper and lower sides across the heat insulating part 470.

The first layer 471, the second layer 472, and the third layer 473 included in the heat insulating part 470 may include insulating materials. Specifically, the first layer 471 and the third layer 473, and the second layer 472 may include insulating materials having different etching rates from each other. With this configuration, when forming the gap 475 in the second layer 472 by etching, it is possible to cause the first layer 471 and the third layer 473 to function as an etching stop layer. This makes it possible to more easily form a larger gap 475 in the second layer 472. For example, in a case where the second layer 472 includes silicon oxide (SiOₓ), the first layer 471 and the third layer 473 may include silicon nitride (SiNₓ).

In the electromagnetic wave detection device 400 according to the present embodiment having the above configuration, it is possible to suppress thermal coupling between the electromagnetic wave absorption layer 430 and the read circuit with large heat capacity by the heat insulating part 470. Consequently, the electromagnetic wave detection device 400 makes it possible to control the temperature gradient in the thickness direction of the electromagnetic wave absorption layer 430 with higher accuracy.

### (4.2. Method of Forming Heat Insulating Part)

Here, a method of forming the heat insulating part 470 in the electromagnetic wave detection device 400 according to the present embodiment is described with reference to FIG. 10A to FIG. 10E. FIG. 10A to FIG. 10E are vertical cross-sectional views of respective steps of the method of forming the heat insulating part 470 in the electromagnetic wave detection device 400 according to the present embodiment. FIG. 10A to FIG. 10E omit illustration of the configuration above the second electrode 420.

First, as illustrated in FIG. 10A, a stacked structure in which the first layer 471 including SiNₓ, the second layer 472 including SiOₓ, and the third layer 473 including SiNₓ are stacked is formed. Furthermore, the second electrode 420 is formed on the first layer 471.

Next, as illustrated in FIG. 10B, by using a patterned resist 474, anisotropic etching is performed from the second electrode 420 side on the first layer 471 between the second electrodes 420, to form an opening 474A penetrating the first layer 471 to reach the second layer 472.

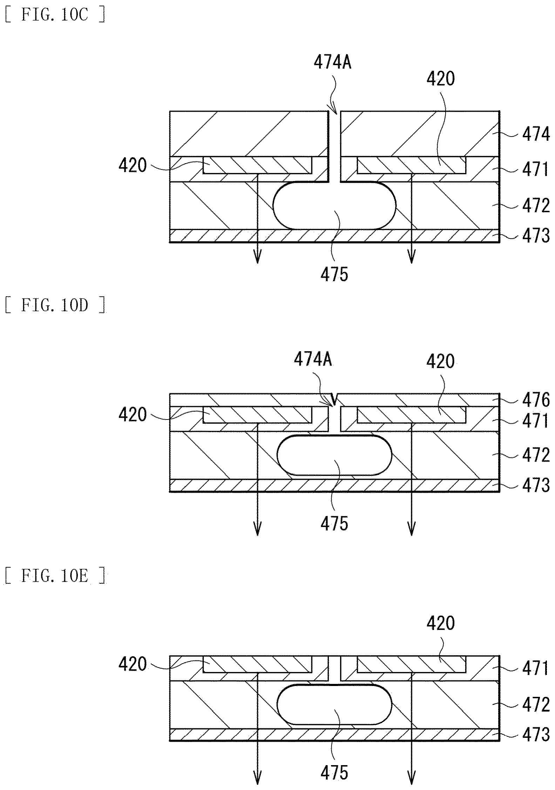

Subsequently, as illustrated in FIG. 10C, isotropic etching is performed on the second layer 472, by introducing aqueous hydrogen fluoride (HF) into the second layer 472 via the opening 474A. The second layer 472 is selectively etched, because SiOₓ included in the second layer 472 has a faster etching rate for the HF than SiNₓ included in the first layer 471 and the third layer 473. It is to be noted that an etching method for the second layer 472 is not limited to the above etching using the aqueous hydrogen fluoride. For example, the etching method for the second layer 472 may be dry etching having selectivity between SiOₓ, and SiNₓ.

Next, as illustrated in FIG. 10D, the resist 474 is removed after the etching of the second layer 472. Thereafter, by using an ALD (Atomic Layer Deposition) method, a blocking layer 476 including SiOₓ is formed along a surface shape of the second electrode 420 and the first layer 471, to block the opening 474A. Thus, the gap 475 is formed inside the second layer 472.

Subsequently, as illustrated in FIG. 10E, it is possible to form the heat insulating part 470 below the second electrode 420, by removing the blocking layer 476 deposited on the second electrode 420 and the first layer 471. Thereafter, it is possible to form the electromagnetic wave absorption layer 430 by applying a carbon nanotube onto the second electrode 420 and the first layer 471. Furthermore, the first electrode 410 and the insulating layer 440 may be sequentially formed on the electromagnetic wave absorption layer 430.

### <5. Fifth Embodiment

### (5.1. Configuration of Electromagnetic Wave Detection Device)

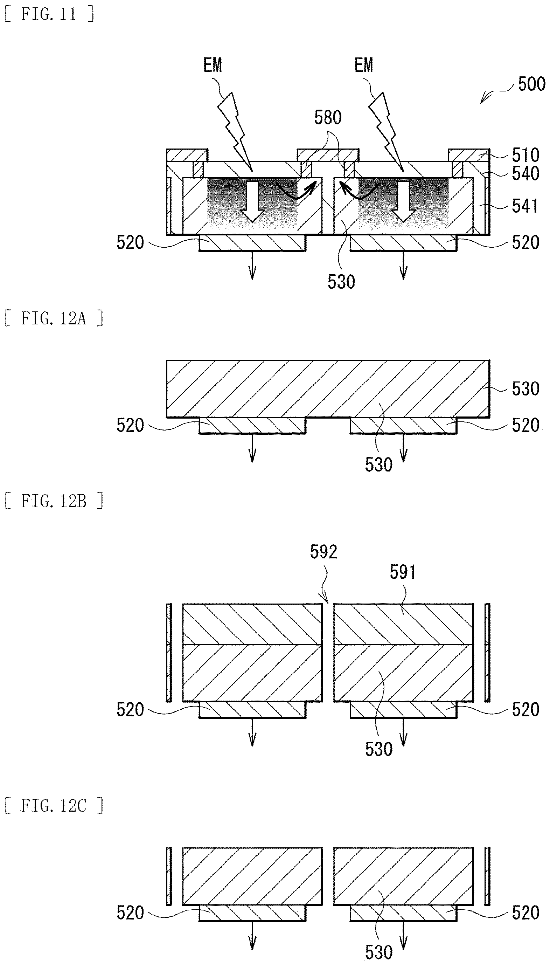

Next, a configuration of an electromagnetic wave detection device according to a fifth embodiment of the present disclosure is described with reference to FIG. 11. FIG. 11 is a schematic diagram illustrating a configuration of a cross section of an electromagnetic wave detection device 500 according to the present embodiment.

As illustrated in FIG. 11, the electromagnetic wave detection device 500 includes, for example, an electromagnetic wave absorption layer 530, a first electrode 510, a second electrode 520, an insulating layer 540, a pixel separation layer 541, and a connection via 580. It is to be noted that the electromagnetic wave absorption layer 530, the first electrode 510, the second electrode 520, and the insulating layer 540 are substantially similar to the electromagnetic wave absorption layer 130, the first electrode 110, the second electrode 120, and the insulating layer 140 described with reference to FIG. 1, and description thereof is therefore omitted here.

The pixel separation layer 541 is provided by using an insulating material to penetrate the electromagnetic wave absorption layer 530 between the pixels in the thickness direction. Specifically, the pixel separation layer 541 may be provided to penetrate, in the thickness direction, the electromagnetic wave absorption layer 530 in a region between the second electrodes 520. By separating the electromagnetic wave absorption layer 530 for each pixel, the pixel separation layer 541 is able to suppress thermal crosstalk between adjacent pixels.

The pixel separation layer 541 may include, for example, an insulating material similar to the insulating layer 540. In such a case, the pixel separation layer 541 may be formed by the same process as the insulating layer 540. In addition, the pixel separation layer 541 may include an insulating material with lower heat conductivity than the electromagnetic wave absorption layer 530. In such a case, the pixel separation layer 541 is able to more reliably separate the pixels of the electromagnetic wave absorption layer 530.

In the electromagnetic wave detection device 500 according to the present embodiment, the insulating layer 540 is formed at the same time as the pixel separation layer 541, and therefore is provided to spread over the entire first principal surface of the electromagnetic wave absorption layer 530. Therefore, the first electrode 510 is electrically coupled to the electromagnetic wave absorption layer 530, via the connection via 580 provided on the insulating layer 540 and penetrating the insulating layer 540. The connection via 580 may include, for example, an electrically conductive material such as aluminum (Al), titanium (Ti), titanium nitride (TiN), tungsten (W), Ni (nickel), or copper (Cu).

In the electromagnetic wave detection device 500 according to the present embodiment having the above configuration, it is possible to physically separate the electromagnetic wave absorption layer 530 for each pixel by the pixel separation layer 541, which makes it possible to further suppress electrical or thermal crosstalk between the pixels.

### (5.2. Method of Manufacturing Electromagnetic Wave Detection Device)

Here, a method of manufacturing the electromagnetic wave detection device 500 according to the present embodiment is described with reference to FIG. 12A to FIG. 12F. FIG. 12A to FIG. 12F are vertical cross-sectional views of respective steps of the method of manufacturing the electromagnetic wave detection device 500 according to the present embodiment.

First, as illustrated in FIG. 12A, the electromagnetic wave absorption layer 530 is formed by applying a carbon nanotube onto the second electrode 520 separated for each pixel.

Next, as illustrated in FIG. 12B, by using a patterned resist 591, anisotropic etching is performed on the electromagnetic wave absorption layer 530 between the second electrodes 520, to form an opening 592 penetrating the electromagnetic wave absorption layer 530.

Subsequently, as illustrated in FIG. 12C, the patterned resist 591 on the electromagnetic wave absorption layer 530 is removed.

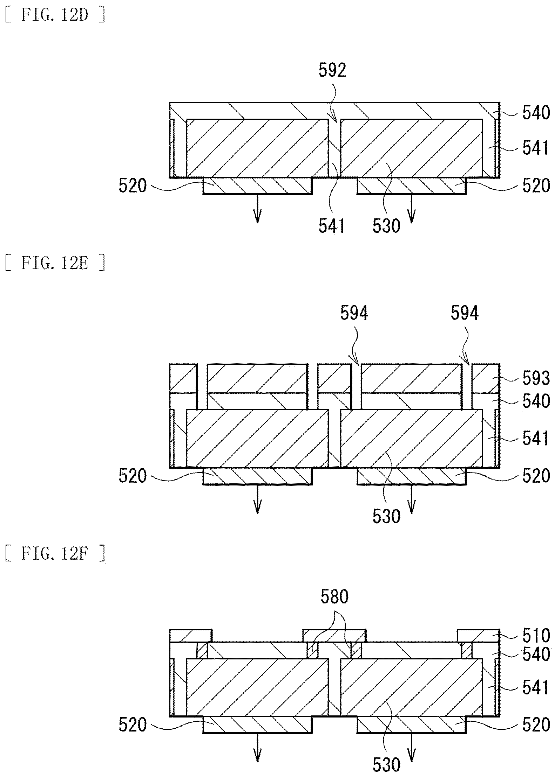

Furthermore, as illustrated in FIG. 12D, by depositing SiOₓ on the electromagnetic wave absorption layer 530 by using the ALD method, the pixel separation layer 541 is formed to fill the opening 592 and the insulating layer 540 is formed on the electromagnetic wave absorption layer 530.

Next, as illustrated in FIG. 12E, by using a patterned resist 593, anisotropic etching is performed on the insulating layer 540 on the electromagnetic wave absorption layer 530, to form an opening 594 penetrating the insulating layer 540.

Subsequently, as illustrated in FIG. 12F, the connection via 580 is formed by filling the opening 594 with an electrically conductive material, and thereafter the first electrode 510 is formed on the connection via 580. This makes it possible to form the first electrode 510 electrically coupled to the electromagnetic wave absorption layer 530.

### <6. Application Examples>

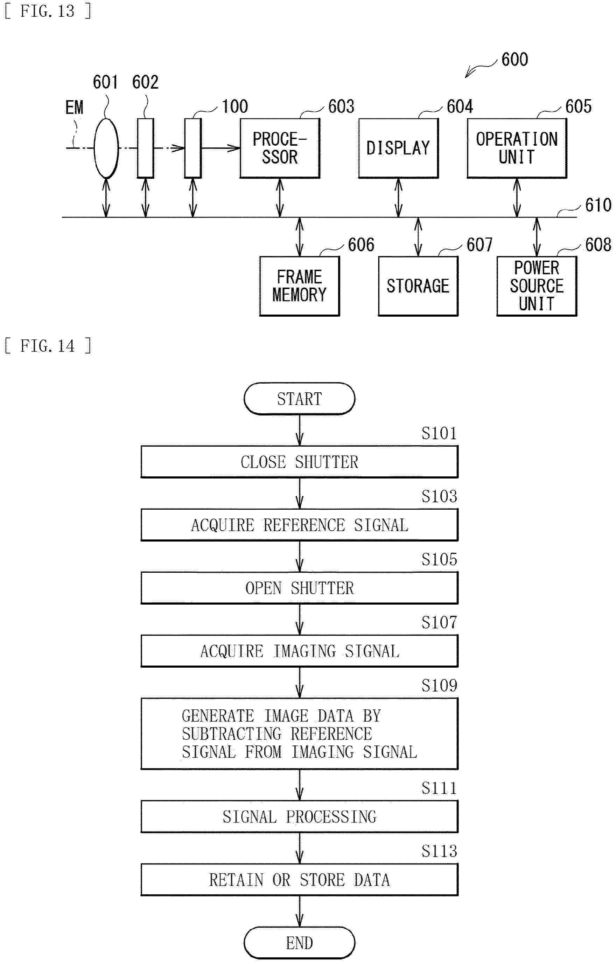

In the following description, application examples of the electromagnetic wave detection device according to one embodiment of the present disclosure are described with reference to FIG. 13 to FIG. 16. Although the following description exemplifies the electromagnetic wave detection device 100 as the electromagnetic wave detection device according to one embodiment of the present disclosure, it is needless to say that the same applies to the electromagnetic wave detection devices 200, 300, 400, and 500.

### (Application to Imaging System)

First, an example of application of the electromagnetic wave detection device 100 according to one embodiment of the present disclosure to an imaging system is described with reference to FIG. 13 and FIG. 14. FIG. 13 is a block diagram illustrating an example of an outline configuration of an electromagnetic wave detection system 600 including the electromagnetic wave detection device 100 according to one embodiment of the present disclosure. FIG. 14 illustrates an example of a flowchart of imaging operation in the electromagnetic wave detection system 600.

As illustrated in FIG. 13, the electromagnetic wave detection system 600 is, for example, a camera system that generates an electromagnetic image of an object by detecting the electromagnetic wave EM emitted from the object by the electromagnetic wave detection device 100.

The electromagnetic wave detection system 600 includes, for example, an optical system 601, a shutter 602, the electromagnetic wave detection device 100 according to one embodiment of the present disclosure, a processor 603, a display 604, an operation unit 605, a frame memory 606, a storage 607, and a power source unit 608. In the electromagnetic wave detection system 600, the electromagnetic wave detection device 100, the processor 603, the display 604, the operation unit 605, the frame memory 606, the storage 607, and the power source unit 608 are coupled to each other via a bus line 610.

The electromagnetic wave detection device 100 detects the electromagnetic wave that has passed through the optical system 601 and the shutter 602, and outputs image data corresponding to the detected electromagnetic wave. Specifically, the electromagnetic wave detection device 100 acquires, as a reference signal, a signal in a case where the shutter 602 is in a closed state, and acquires, as an imaging signal, a signal in a case where the shutter 602 is in the closed state. The shutter 602 controls whether the electromagnetic wave detection device 100 is irradiated with the electromagnetic wave. The electromagnetic wave detection device 100 outputs, as the image data, a signal obtained by subtracting the reference signal in the case where the shutter 602 is in the closed state from the imaging signal in the case where the shutter 602 is in an open state.

The processor 603 is a signal processing circuit that processes a signal (i.e., image data) outputted from the electromagnetic wave detection device 100. The frame memory 606 temporarily retains the image data processed by the processor 603 in units of frames. The display 604 includes, for example, a panel-type display device such as a liquid crystal panel or an organic EL (Electro Luminescence) panel, and displays image data generated by the electromagnetic wave detection device 100. The storage 607 includes a recording medium such as a semiconductor memory or a hard disk, and records the image data generated by the electromagnetic wave detection device 100 thereon. The operation unit 605 outputs operation commands for various functions of the electromagnetic wave detection system 600, in accordance with user's operations. The power source unit 608 includes various power sources that supply operation power for the electromagnetic wave detection device 100, the processor 603, the display 604, the operation unit 605, the frame memory 606, and the storage 607.

Next, an imaging procedure in the electromagnetic wave detection system 600 is described. First, imaging is started by a user operating the operation unit 605.

At this time, as illustrated in FIG. 14, the electromagnetic wave detection system 600 puts the shutter 602 into the closed state (SI01), and acquires, as a reference signal, a signal in a state in which the electromagnetic wave detection device 100 is not irradiated with the electromagnetic wave EM, from the electromagnetic wave detection device 100 (SI03). Subsequently, the electromagnetic wave detection system 600 puts the shutter 602 into the open state (S105), and acquires, as an imaging signal, a signal in a state in which the electromagnetic wave detection device 100 is irradiated with the electromagnetic wave EM, from the electromagnetic wave detection device 100 (SI07). Subsequently, the electromagnetic wave detection system 600 generates image data, by subtracting the reference signal in the case where the shutter 602 is in the closed state from the imaging signal in the case where the shutter 602 is in the open state (S109). Next, the processor 603 performs predetermined signal processing (e.g., noise-reducing processing) on the image data outputted from the electromagnetic wave detection device 100 (S111). The processor 603 causes the frame memory 606 to retain the image data subjected to the predetermined signal processing. Thereafter, the frame memory 606 causes the storage 607 to store the image data (SI13). The imaging in the electromagnetic wave detection system 600 is performed in accordance with the above-described flow.

In the present application example, the electromagnetic wave detection device 100 according to one embodiment of the present disclosure is applied to the electromagnetic wave detection system 600. The electromagnetic wave detection system 600 may be used for a camera system for nondestructive inspection or a camera system for thermography, for example.

### (Application to Mobile Body Control System)

The technology according to the present disclosure (the present technology) is applicable to a variety of products. For example, the technology according to the present disclosure may be achieved as a device mounted on any type of mobile body such as a vehicle, an electric vehicle, a hybrid electric vehicle, a motorcycle, a bicycle, a personal mobility, an airplane, a drone, a vessel, or a robot.

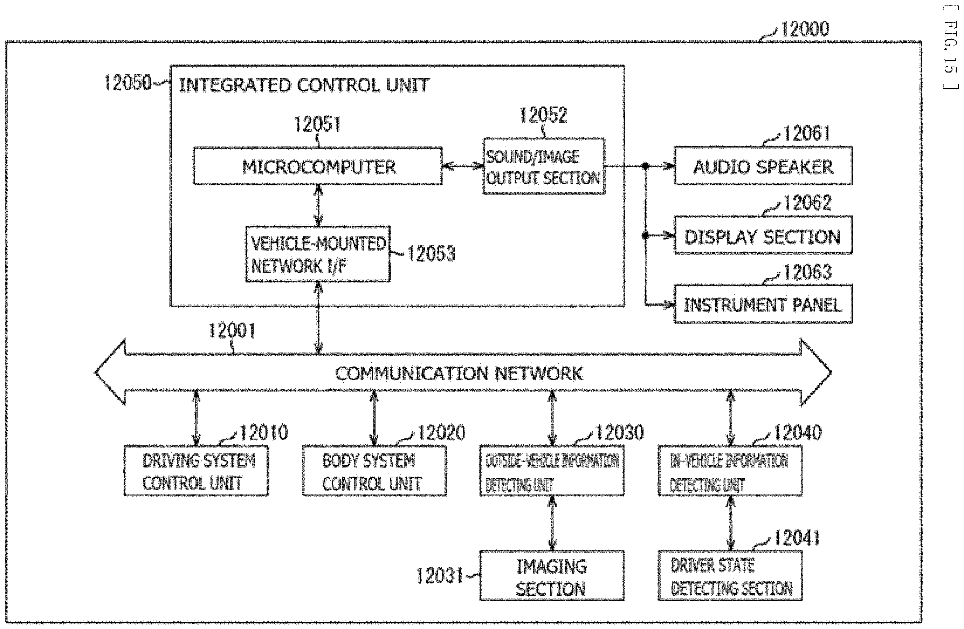

FIG. 15 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 15, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automatic driving, which makes the vehicle to travel autonomously without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 15, an audio speaker 12061, a display section 12062, and an instrument panel 12063 are illustrated as the output device. The display section 12062 may, for example, include at least one of an on-board display and a head-up display.

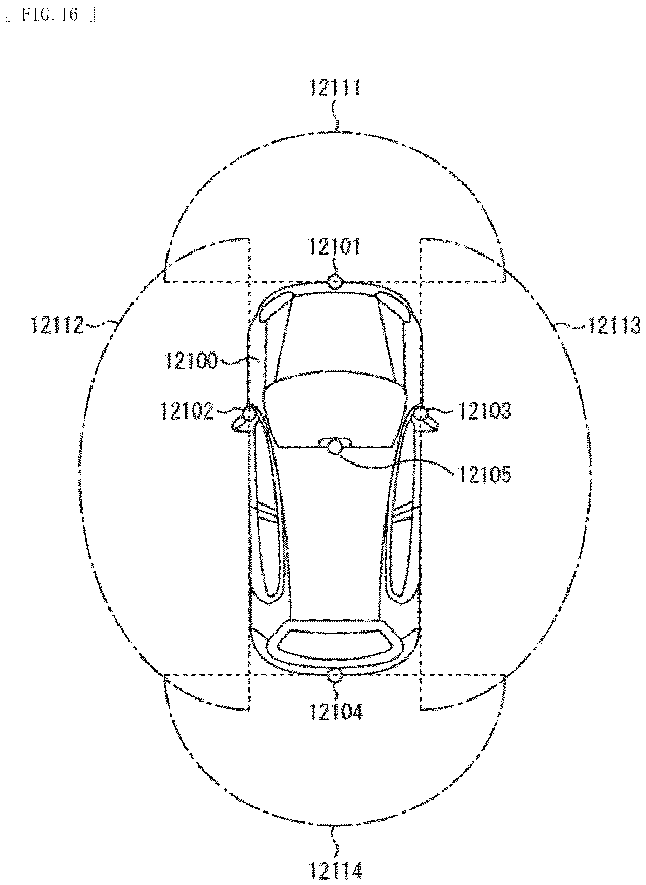

FIG. 16 is a diagram depicting an example of the installation position of the imaging section 12031.

In FIG. 16, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 16 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automatic driving that makes the vehicle travel autonomously without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

Described above is an example of the mobile body control system to which the technology according to the present disclosure is applicable. The technology according to the present disclosure is applicable to the imaging section 12031 of the above-described components. The technology according to the present disclosure makes it possible to detect light or an electromagnetic wave other than visible light, which is invisible to human. This enables the mobile body control system to perform more advanced control using a detection result. In addition, the technology according to the present disclosure makes it possible to achieve further improvement in performance or reduction in cost of the electromagnetic wave detection device 100 that detects light or an electromagnetic wave other than visible light. This enables the electromagnetic wave detection device 100 to be applied to a wider variety of targets.

The technology according to the present disclosure has been described above with reference to the first to fifth embodiments. However, the technology according to the present disclosure is not limited to the above embodiments, etc., and various modifications may be made. In addition, the above first to fifth embodiments may be combined with each other.

Furthermore, not all of the configurations and operations described in the embodiments are necessary as the configurations and operations of the present disclosure. For example, among components in the embodiments, the component that is not described in the independent claim reciting the most generic concept of the present disclosure should be understood as an optional component.

Terms used throughout this specification and the appended claims should be construed as "non-limiting" terms. For example, the term "including" or "included" should be construed as "not limited to what is described as being included". The term "having" should be construed as "not limited to what is described as being had".

Terms used in this specification include terms that are used for convenience in description only and are not used to limit configurations and operations. For example, terms such as "right", "left", "on", and "under" only indicate directions on the drawing being referred to. Further, the terms "inside" and "outside" only indicate, respectively, a direction toward the center of a component of interest and a direction away from the center of a component of interest. The same applies to terms similar to these and to terms with the same purpose.

It is to be noted that the technology according to the present disclosure may have the following configurations. The technology according to the present disclosure having the following configurations makes it possible to generate a temperature gradient in the thickness direction of the electromagnetic wave absorption layer, thereby thermoelectrically converting the temperature gradient generated in the thickness direction of the electromagnetic wave absorption layer into electromotive force. Thus, in the electromagnetic wave detection device using the technology according to the present disclosure, it is possible to thermoelectrically convert the temperature gradient into the electromotive force with an effective structure, as compared with a case of thermoelectrically converting a temperature gradient generated in the in-plane direction of the electromagnetic wave absorption layer. Consequently, the electromagnetic wave detection device using the technology according to the present disclosure is able to achieve further improvement in performance or reduction in cost. Effects of the technology according to the present disclosure are not necessarily limited to the effects described herein, and may be any of the effects described in the present disclosure.
(1) An electromagnetic wave detection device including:
   an electromagnetic wave absorption layer including a low-dimensional electronic material that absorbs an electromagnetic wave;
   a first electrode provided on a first principal surface of the electromagnetic wave absorption layer;
   a second electrode provided on a second principal surface of the electromagnetic wave absorption layer, the second principal surface being opposed to the first principal surface; and
   a read circuit that reads, from the second electrode, a signal generated by thermoelectric conversion of heat generated by the electromagnetic wave absorption layer that has absorbed the electromagnetic wave.
(2) The electromagnetic wave detection device according to (1), in which
   the first electrode is provided to spread over the entire first principal surface, and
   the first electrode is provided with a plurality of apertures two-dimensionally arranged.
(3) The electromagnetic wave detection device according to (2), in which each of the plurality of apertures configures a pixel that detects the electromagnetic wave incident from side of the first principal surface.
(4) The electromagnetic wave detection device according to (2) or (3), in which the second electrodes are provided to be separated from each other in regions on the second principal surface that correspond to the plurality of apertures.
(5) The electromagnetic wave detection device according to any one of (2) to (4), in which a pixel separation layer is further provided to separate the electromagnetic wave absorption layer for each of regions provided with the plurality of apertures.
(6) The electromagnetic wave detection device according to (5), in which the pixel separation layer is provided to penetrate the electromagnetic wave absorption layer.
(7) The electromagnetic wave detection device according to any one of (1) to (6), in which a shield electrode is further provided between the second electrodes on the second principal surface.
(8) The electromagnetic wave detection device according to any one of (1) to (7), in which the low-dimensional electronic material includes a material in which internal electron transfer is restricted within a region of two or less dimensions.
(9) The electromagnetic wave detection device according to (8), in which the low-dimensional electronic material includes at least any one or more of a carbon nanotube or graphene.
(10) The electromagnetic wave detection device according to any one of (1) to (9), in which
   an insulating layer is further provided on the electromagnetic wave absorption layer and the first electrode, and
   the insulating layer has at least any one or more of: lower heat conductivity than the electromagnetic wave absorption layer; or lower absorptance for the electromagnetic wave than the electromagnetic wave absorption layer.
(11) The electromagnetic wave detection device according to any one of (1) to (10), in which a buffer layer is further provided between the electromagnetic wave absorption layer and the second electrode.
(12) The electromagnetic wave detection device according to (11), in which, in a case where the low-dimensional electronic material is a p-type compound, the buffer layer includes a buffer material with a smaller electron affinity than the low-dimensional electronic material.
(13) The electromagnetic wave detection device according to (11), in which, in a case where the low-dimensional electronic material is an n-type compound, the buffer layer includes a buffer material with a larger ionization potential than the low-dimensional electronic material.
(14) The electromagnetic wave detection device according to any one of (1) to (13), in which a heat insulating part including a gap is further provided between the second electrode and the read circuit.
(15) The electromagnetic wave detection device according to any one of (1) to (14), in which the electromagnetic wave absorbed by the electromagnetic wave absorption layer has a frequency of 100 GHz or more and 75 THz or less.
(16) An electromagnetic wave detection system including:
   an electromagnetic wave detection device; and
   a shutter that controls incidence of an electromagnetic wave on the electromagnetic wave detection device, in which
   the electromagnetic wave detection device includes
      an electromagnetic wave absorption layer including a low-dimensional electronic material that absorbs the electromagnetic wave,
      a first electrode provided on a first principal surface of the electromagnetic wave absorption layer,
      a second electrode provided on a second principal surface of the electromagnetic wave absorption layer, the second principal surface being opposed to the first principal surface, and
      a read circuit that reads, from the second electrode, a signal generated by thermoelectric conversion of heat generated by the electromagnetic wave absorption layer that has absorbed the electromagnetic wave.
(17) An electromagnetic wave detection method including:
   absorbing an electromagnetic wave by a low-dimensional electronic material included in an electromagnetic wave absorption layer whose principal surfaces opposed to each other are sandwiched between a first electrode and a second electrode;
   performing thermoelectric conversion of heat generated by the electromagnetic wave absorption layer by absorption of the electromagnetic wave; and
   reading a signal generated by the thermoelectric conversion from the second electrode.

This application claims the benefit of Japanese Priority Patent Application No. 2019-186911 filed with the Japan Patent Office on October 10, 2019, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. An electromagnetic wave detection device comprising:
an electromagnetic wave absorption layer including a low-dimensional electronic material that absorbs an electromagnetic wave;
a first electrode provided on a first principal surface of the electromagnetic wave absorption layer;
a second electrode provided on a second principal surface of the electromagnetic wave absorption layer, the second principal surface being opposed to the first principal surface; and
a read circuit that reads, from the second electrode, a signal generated by thermoelectric conversion of heat generated by the electromagnetic wave absorption layer that has absorbed the electromagnetic wave.

2. The electromagnetic wave detection device according to claim 1, wherein
the first electrode is provided to spread over the entire first principal surface, and
the first electrode is provided with a plurality of apertures two-dimensionally arranged.

3. The electromagnetic wave detection device according to claim 2, wherein each of the plurality of apertures configures a pixel that detects the electromagnetic wave incident from side of the first principal surface.

4. The electromagnetic wave detection device according to claim 2, wherein the second electrodes are provided to be separated from each other in regions on the second principal surface that correspond to the plurality of apertures.

5. The electromagnetic wave detection device according to claim 2, wherein a pixel separation layer is further provided to separate the electromagnetic wave absorption layer for each of regions provided with the plurality of apertures.

6. The electromagnetic wave detection device according to claim 5, wherein the pixel separation layer is provided to penetrate the electromagnetic wave absorption layer.

7. The electromagnetic wave detection device according to claim 1, wherein a shield electrode is further provided between the second electrodes on the second principal surface.

8. The electromagnetic wave detection device according to claim 1, wherein the low-dimensional electronic material comprises a material in which internal electron transfer is restricted within a region of two or less dimensions.

9. The electromagnetic wave detection device according to claim 8, wherein the low-dimensional electronic material includes at least any one or more of a carbon nanotube or graphene.

10. The electromagnetic wave detection device according to claim 1, wherein
an insulating layer is further provided on the electromagnetic wave absorption layer and the first electrode, and
the insulating layer has at least any one or more of: lower heat conductivity than the electromagnetic wave absorption layer; or lower absorptance for the electromagnetic wave than the electromagnetic wave absorption layer.

11. The electromagnetic wave detection device according to claim 1, wherein a buffer layer is further provided between the electromagnetic wave absorption layer and the second electrode.

12. The electromagnetic wave detection device according to claim 11, wherein, in a case where the low-dimensional electronic material is a p-type compound, the buffer layer includes a buffer material with a smaller electron affinity than the low-dimensional electronic material.

13. The electromagnetic wave detection device according to claim 11, wherein, in a case where the low-dimensional electronic material is an n-type compound, the buffer layer includes a buffer material with a larger ionization potential than the low-dimensional electronic material.

14. The electromagnetic wave detection device according to claim 1, wherein a heat insulating part including a gap is further provided between the second electrode and the read circuit.

15. The electromagnetic wave detection device according to claim 1, wherein the electromagnetic wave absorbed by the electromagnetic wave absorption layer has a frequency of 100 GHz or more and 75 THz or less.

16. An electromagnetic wave detection system comprising:
an electromagnetic wave detection device; and
a shutter that controls incidence of an electromagnetic wave on the electromagnetic wave detection device, wherein
the electromagnetic wave detection device includes
an electromagnetic wave absorption layer including a low-dimensional electronic material that absorbs the electromagnetic wave,
a first electrode provided on a first principal surface of the electromagnetic wave absorption layer,
a second electrode provided on a second principal surface of the electromagnetic wave absorption layer, the second principal surface being opposed to the first principal surface, and
a read circuit that reads, from the second electrode, a signal generated by thermoelectric conversion of heat generated by the electromagnetic wave absorption layer that has absorbed the electromagnetic wave.

17. An electromagnetic wave detection method comprising:
absorbing an electromagnetic wave by a low-dimensional electronic material included in an electromagnetic wave absorption layer whose principal surfaces opposed to each other are sandwiched between a first electrode and a second electrode;
performing thermoelectric conversion of heat generated by the electromagnetic wave absorption layer by absorption of the electromagnetic wave; and
reading a signal generated by the thermoelectric conversion from the second electrode.
